# EUROPÄISCHE PATENTSCHRIFT

(11) **EP 3 040 149 B1**
(45) Veröffentlichungstag und Bekanntmachung des Hinweises auf die Patenterteilung: **01.11.2017**
(21) Anmeldenummer: 15198479.6
(22) Anmeldetag: 08.12.2015
(51) Int. Cl.: B23K 1/08, B23K 3/06

(54) **LÖTVORRICHTUNG MIT GASVERTEILUNG**
SOLDERING DEVICE WITH GAS DISTRIBUTION
DISPOSITIF DE SOUDURE AVEC DISTRIBUTION DE GAZ

(30) Priorität: 09.12.2014 DE 102014018165
(43) Veröffentlichungstag der Anmeldung: 06.07.2016
(73) Patentinhaber: Messer Austria GmbH, 2352 Gumpoldskirchen (AT); Messer Group GmbH, 65812 Bad Soden (DE)
(72) Erfinder: Tauchmann, Jens, 47259 Duisburg (DE); Hatz, Gottfried, 8431 Gralla (AT)
(74) Vertreter: Münzel, Joachim R.

(56) Entgegenhaltungen:
- EP-A1- 1 779 956
- DE-A1- 19 749 184
- DE-A1- 19 749 185
- DE-C1- 19 912 718
- US-A- 5 176 307

## Beschreibung

Die Erfindung betrifft eine Lötvorrichtung zum Löten von Flachbaugruppen, mit einer einen Lotbehälter abdeckenden Haubenkonstruktion, die einen mit einer Klappe gegen das Eindringen von Umgebungsluft gesicherten Eingang und einen mit einer Klappe gegen das Eindringen von Umgebungsluft gesicherten Ausgang für durch die Haubenkonstruktion hindurchzuführende und innerhalb der Haubenkonstruktion mit einer Lotwelle in Kontakt zu bringende Flachbaugruppen aufweist, und mit einer Gasdüse zum Einlassen und Verteilen eines Schutzgases in die Haubenkonstruktion, welche Gasdüse zumindest einen mit zumindest einer Austrittsöffnung ausgerüsteten Düsenkörper umfasst.

Bei der Inertisierung von Wellenlötanlagen werden unterschiedlich ausgebildete und angeordnete Systeme zum Eintragen eines Schutzgases eingesetzt. Sie haben die Aufgabe, die Haubenkonstruktion des Lotbehälters zu inertisieren und damit die Qualität der Lötverbindungen den gewachsenen Anforderungen anzupassen. Mit dem Einsatz eines Schutzgases, insbesondere von Stickstoff oder eines reduzierend wirkenden Gases, können die Prozessfenster vergrößert, die Benetzung der zu verlötenden Stellen verbessert und die Krätzebildung reduziert werden.

Um die Vermischung mit Luftsauerstoff aus der Umgebungsatmosphäre zu begrenzen, werden die Eingänge und Ausgänge, durch die die Flachbaugruppen in das Innere der Haubenkonstruktion bzw. aus dieser heraus geführt werden, mit Gasvorhängen, Schleusen oder Klappenanordnungen gesichert. Zudem werden die Haubenkonstruktionen in Transportrichtung der Flachbaugruppen in mehrere Tunnelabschnitte unterteilt, die gleichfalls durch derartige Anordnungen strömungstechnisch weitgehend voneinander getrennt werden. Lötvorrichtungen dieser Art werden beispielsweise in den Druckschriften DE 41 42 436 A1, DE 197 49 184 A1 oder DE 199 12 718 C1 beschrieben.

In der EP 1 035 939 B1, die dem Oberbegriff vom Anspruch 1 zugrundeliegt, wird ein Gasverteiler zum Einlassen und Verteilen eines nichtoxidierenden Gases in eine mit einer Haubenkonstruktion ausgerüsteten Mehrkammer-Lötvorrichtung beschrieben. Der Gasverteiler umfasst mehrere Gasdüsen, die jeweils einen quer zur Längserstreckung der Lötvorrichtung angeordneten Düsenkörper aufweisen, in dem eine nach unten, also zu einem das Lotbad aufnehmenden Lötbehälter hin gerichtete Austrittsöffnung angeordnet ist, die sich schlitzförmig über die ganze Breite des Lotbehälters erstreckt. Um turbulente Strömungen beim Austritt des Gases zu verhindern, ist im Innern des Düsenkörpers eine erste Entspannungskammer vorgesehen, die über mindestens eine Öffnung mit einer weiteren Entspannungskammer verbunden ist, in der wiederum die Austrittsöffnungen vorgesehen sind.

Die EP 1 779 956 A1 beschreibt ebenfalls eine Lötvorrichtung zum Löten von Flachbaugruppen, die mit einer Gasdüse zum Einlassen und Verteilen eines nichtoxidierenden Gas in eine einen Lotbehälter der Lötvorrichtung abdeckende Haubenkonstruktion ausgerüstet ist. Um eine gleichmäßige Verteilung des Schutzgases zu erzielen, sind im Düsenkörper der Gasdüse voneinander beabstandet angeordnete Austrittsöffnungen angeordnet, die als in Richtung der Gasströmung schräg verlaufende Durchführungen ausgebildet sind.

Allerdings weisen die bekannten Düsensysteme Nachteile bei der Verteilung des aus der in der Regel als Rohr oder Schlauch ausgebildeten Zuleitung zugeführten Schutzgases in und entlang der Düse auf. Insbesondere besteht die Gefahr, dass das Gas ungleichmäßig an den Austrittsöffnungen der Düse austritt, wodurch es in der Folge zur Entstehung unerwünschter turbulenter Gasströmungen innerhalb der Haubenkonstruktion kommt, durch die der Eintrag von Umgebungsatmosphäre begünstigt wird. Um zu einer vorgegebenen minimalen Sauerstoffkonzentration im gesamten Lotbadbereich zu kommen, muss daher eine vergleichsweise große Menge an Schutzgas zugeführt werden. Weiterhin besteht insbesondere für die als Mehrkammersysteme ausgebildeten Gasdüsen ein Verschmutzungsproblem, da an den Austrittsöffnungen Dämpfe des Lötprozesses kondensieren können, die im Laufe der Betriebszeit die Strömungsverhältnisse an den Düsen verändern.

Weiterhin vernachlässigen die bekannten Systeme, dass ein wesentlicher Eintrag von Sauerstoff in eine Wellenlötanlage über die Transportträger der Flachbaugruppe, den sogenannten Nutzen, oder durch die Flachbaugruppe selbst erfolgt. Zum einen müssen Schleusen oder Klappen beim Durchgang des Nutzens bzw. der Flachbaugruppe geöffnet werden; sofern ein Gasvorhang zum Einsatz kommt, wird dessen Strömungsverlauf durch die unregelmäßig geformte Oberfläche der Flachbaugruppe empfindlich gestört. Zum anderen lagert sich vor dem Eintritt der Flachbaugruppe in die Haubenkonstruktion Umgebungsluft zwischen den einzelnen Bauteilen der Flachbaugruppe an, die zumindest teilweise in die Haubenkonstruktion mitgeführt wird. Somit kann Luftsauerstoff bis zur Lötzone gelangen.

Der Erfindung liegt daher die Aufgabe zugrunde, eine Lötvorrichtung zu schaffen, die die Nachteile des Standes der Technik überwindet und bei der der Eintrag von Sauerstoff aus der Umgebungsluft weiter reduziert ist.

Diese Aufgabe wird durch eine Lötvorrichtung mit den Merkmalen des Anspruchs 1 gelöst. Vorteilhafte Ausgestaltungen sind in den Unteransprüchen angegeben.

Eine Lötvorrichtung der eingangs genannten Art und Zweckbestimmung ist erfindungsgemäß also dadurch gekennzeichnet, dass zumindest eine Klappe mit einer integrierten Gasdüse ausgerüstet ist, wobei der Düsenkörper der Gasdüse innerhalb einer Hohlkammer der Klappe angeordnet ist und die Hohlkammer auf einer in einem Schließzustand der Klappe dem Innenraum der Haubenkonstruktion zugewandten Seitenfläche wenigstens eine Strömungsöffnung aufweist.

Erfindungsgemäß ist also eine dem Zuführen von Schutzgas dienende Gasdüse in eine Klappe integriert, mittels der der Eingang und/oder der Ausgang der Haubenkonstruktion gegen das Eindringen von Umgebungsluft gesichert wird. Dazu ist innerhalb der Klappe eine Hohlkammer angeordnet, innerhalb der ein Düsenkörper der Gasdüse angeordnet ist. Die Hohlkammer weist an einer Seitenfläche, die in einem Schließzustand der Klappe einem Innenraum der Haubenkonstruktion zugewandt ist, wenigstens eine Strömungsöffnung auf. Das Schutzgas fließt also aus der Gasdüse in die Hohlkammer und von dort über die Strömungsöffnung in das Innere der Haubenkonstruktion ein, gleichzeitig schottet die Klappe in ihrem Schließzustand den Innenraum der Haubenkonstruktion gegen das Eindringen von Sauerstoff aus der Umgebungsatmosphäre ab. Im Schließzustand der Klappe wird also der Innenraum der Haubenkonstruktion mit einem gleichmäßigen, von den Klappen in Richtung auf die Lötzone laufenden Schutzgasstrom geflutet. Dabei entsteht im Innern der Haubenkonstruktion ein geringer Überdruck gegenüber dem Druck der Umgebungsatmosphäre, der das Eindringen von Luftsauerstoff weiter unterdrückt.

Die erfindungsgemäße, mit einer integrierten Gasdüse ausgerüstete Klappe kann im Übrigen auch ergänzend zu Gasverteilern bzw. Gasdüsen, wie sie aus dem oben zitierten Stand der Technik bekannt sind und insbesondere den Bereich der Lötzone direkt mit Schutzgas beaufschlagen, zum Einsatz kommen. Als Schutzgas kommt bevorzugt ein Inertgas, wie beispielsweise Stickstoff oder ein Edelgas, oder ein reduzierend wirkendes Gas zum Einsatz.

Bevorzugt ist die Klappe derart verschwenkbar an der Haube angelenkt, dass im Öffnungszustand der Klappe die Strömungsöffnung der Hohlkammer in Richtung auf die die jeweilige Öffnung der Haubenkonstruktion durchlaufenden Flachbaugruppen gerichtet ist. Der aus der Austrittsöffnung austretende Gasstrom fungiert so während des Durchtritts der Flachbaugruppe als Gasvorhang und spült die am jeweiligen Nutzen und/oder der Flachbaugruppe anhaftende Luft ab. Auf diese Weise wird auch beim Einfahren der Flachbaugruppen in das Innere der Haubenkonstruktion und/oder bei deren Ausfahren aus der Haubenkonstruktion das Eindringen von Luftsauerstoff wirksam vermieden.

Weiterhin ist es vorteilhaft, Maßnahmen vorzusehen, die einen starken, gerichteten Strom des Schutzgases beim Ausströmen aus der Hohlkammer in die Haubenkonstruktion vermeiden. Dazu gehört insbesondere, dass die Fläche der Strömungsöffnung der Hohlkammer möglichst groß gewählt wird. Bevorzugt erstreckt sie sich über eine Teilfläche der dem Innenraum der Haubenkonstruktion zugewandten Seitenfläche, die den überwiegenden Teil dieser Fläche ausmacht. Alternativ können auch wenige, beispielsweise zwei, drei oder vier Strömungsöffnungen zu Einsatz kommen, die insgesamt einen möglichst großen Teil der betreffenden Seitenfläche einnehmen.

In einer besonders vorteilhaften Ausgestaltung der Erfindung ist die Strömungsöffnung bzw. sind die Strömungsöffnungen mit einem als Gewebe, Draht- oder Maschengeflecht ausgebildeten Strömungskörper ausgerüstet. Das Schutzgas strömt in diesem Fall also durch die Vielzahl der kleinen, im Gewebe des Draht- oder Maschengeflechtes vorhandenen und gleichmäßig über die Fläche des Strömungskörpers verteilte Öffnungen in das Innere der Haubenkonstruktion ein. Alternativ zu einem als Gewebe, Draht- oder Maschengeflecht ausgebildeten Strömungskörper in einer großen Strömungsöffnung oder wenigen großen Strömungsöffnungen bietet sich ein Feld aus einer Vielzahl, beispielsweise 100 oder mehr, Strömungsöffnungen an, die durch die Wand der Hohlkammer hindurchgeführt sind. Bevorzugt erstreckt sich in diesem Fall das Feld der Strömungsöffnungen über einen großen Teil der dem Innenraum der Haubenkonstruktion zugewandten Seitenfläche der Hohlkammer. Die Strömungsöffnungen sind bevorzugt möglichst gleichmäßig über die Fläche dieses Feldes verteilt, beispielsweise äquidistant zueinander angeordnet.

Eine ebenfalls vorteilhafte Ausgestaltung der Erfindung sieht zudem vor, die Hohlkammer insgesamt mit einem gasdurchlässigen Strömungsdämpfer, beispielsweise aus Stahl- oder Glaswolle, zu füllen.

Die in der Hohlkammer der Klappe angeordnete Gasdüse ist zweckmäßigerweise so ausgestaltet, dass bereits innerhalb der Hohlkammer eine möglichst gleichmäßige Verteilung des Schutzgases gewährleistet wird. Dies wird beispielsweise mit der Wahl von Gasdüsen der Art erreicht, wie sie in der EP 1 035 939 B1 oder EP 1 779 956 A1 beschrieben wird, auf die hier ausdrücklich Bezug genommen wird. Bevorzugt erstreckt sich der Düsenkörper der Gasdüse innerhalb der Hohlkammer der Klappe im wesentlichen horizontal und quer zur Transportrichtung der Flachbaugruppen. Dabei ist er bevorzugt mit einer Mehrzahl von in seiner Längsrichtung voneinander beabstandeten Austrittsöffnungen ausgerüstet. Bei den Austrittsöffnungen handelt es sich um Durchführungen durch die Wand des Düsenkörpers, die beispielsweise kreisförmigen Querschnitt und/oder die Form von Längs- oder (in Transportrichtung gesehen) Diagonalschlitzen aufweisen.

Eine weitere Unterdrückung gerichteter Strömungen im Innern der Haubenkonstruktion kann dadurch erzielt werden, dass den Austrittsöffnungen des Düsenkörpers ein Diffusor zum Umlenken der aus den Austrittsöffnungen austretenden gerichteten Gasströmungen zugeordnet ist. Im einfachsten Fall wird dies dadurch realisiert, dass der Ausstoß des Schutzgases aus den Austrittsöffnungen in Richtung auf eine Innenfläche der Hohlkammer erfolgt, in der keine Strömungsöffnung vorliegt, d.h. an denen der Gasstrom zwangsläufig umgelenkt wird. Es sind jedoch auch andere Möglichkeiten zur Realisierung eines Diffusors vorstellbar, wie beispielsweise ein innerhalb der Hohlkammer angeordnetes Umlenkblech.

In einer abermals zweckmäßigen Ausgestaltung der Erfindung sind Maßnahmen vorgesehen, mittels denen ein gleichmäßiger Austrag des Schutzgases aus dem Düsenkörper ermöglicht wird. Dies ist insbesondere dann erforderlich, wenn der Düsenkörper nur an einer Stirnseite mit einer Gaszuleitung strömungsverbunden ist, jedoch das Schutzgas gleichmäßig aus allen Austrittsöffnungen ausströmen soll. Eine zweckmäßige Maßnahme ist in diesem Fall, dass sich der Innenquerschnitt des Düsenkörpers - betrachtet von einem mit dem Düsenkörper verbundenen Gaszuleitungsrohr - verjüngt. Dadurch wird der längs des Düsenkörpers aufgrund des Strömungswiderstands im Düsenkörper auftretende Druckabfall durch eine Vergrößerung der Strömungsgeschwindigkeit kompensiert. Eine ebenfalls vorteilhafte Maßnahme dieser Art besteht darin, dass sich - wiederum gesehen von einem mit dem Düsenkörper verbundenen Gaszuleitungsrohr - die Abstände aufeinander folgender Austrittsöffnungen des Düsenkörpers verkleinern und/oder die Querschnittsöffnungen der Austrittsöffnungen des Düsenkörpers vergrößern.

In einer bevorzugten Ausführungsform der Erfindung handelt es sich bei der Lötvorrichtung um eine Mehrkammer-Lötvorrichtung, bei der die Haubenkonstruktion in eine Mehrzahl von strömungstechnisch voneinander trennbaren Hohlkammern unterteilt ist. Die Strömungstrennung der Hohlkammern voneinander erfolgt dabei zumindest für einen Teil der Hohlkammern jeweils mittels einer mit einer Gasdüse ausgerüsteten Klappe entsprechend der vorliegenden Erfindung.

Ein Ausführungsbeispiel der Erfindung ist in den Zeichnungen dargestellt und wird im folgenden näher beschrieben. In schematischen Ansichten zeigen:
- Fig. 1:: Eine Darstellung einer Lötvorrichtung im Längsschnitt,
- Fig. 2:: eine Klappe der Lötvorrichtung aus Fig. 1 in einem Längsschnitt und
- Fig. 3:: die Klappe aus Fig. 2 in einem Querschnitt entlang der Linie III - III in Fig. 2.

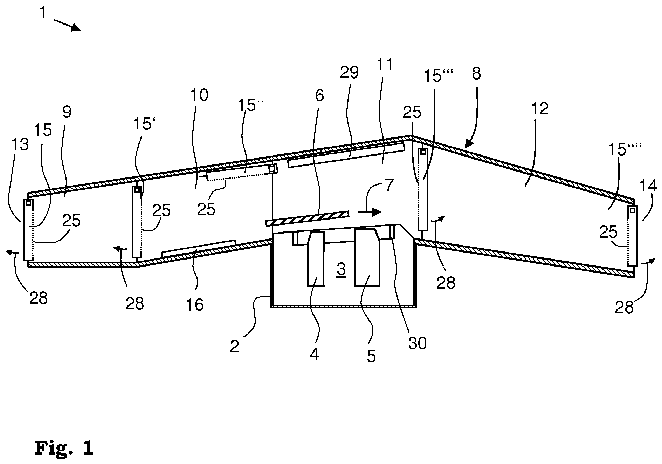

Die in Fig. 1 gezeigte Lötvorrichtung 1 umfasst ein in einem Lotbehälter 2 aufgenommenes Lotbad 3, das mit Lötdüsen 4, 5 zur Erzeugung von Lotwellen ausgerüstet ist. Die Lotwellen dienen dazu, die Unterseite einer Flachbaugruppe 6 mit Lot zu benetzen, die mittels hier nicht gezeigter Transportmittel, den sogenannten Nutzen, in Richtung des Pfeils 7 durch die Lötvorrichtung 1 geführt wird. Die oberhalb des Lotbades 3 ausmündenden Lötdüsen 4, 5 weisen jeweils einen sich horizontal und quer zur Transportrichtung der Flachbaugruppen 6 erstreckenden Düsenschlitz auf. In der Ausführungsform nach Fig. 1 ist die Lötdüse 4 dabei in an sich bekannter Weise als Auftragsdüse und die in Transportrichtung nachfolgende Lötdüse 5 als Abstreifdüse ausgebildet.

Um das Löten der Flachbaugruppen 6 unter Schutzgas zu ermöglichen, ist die Lötvorrichtung 1 mit einer Haubenkonstruktion 8 ausgerüstet, die in mehrere Tunnelsegmente 9, 10, 11, 12 unterteilt ist, den Vortunnel 9, den Vorheizbereich 10, den Lötwellenbereich 11 und den Auslauftunnel 12. Am Vortunnel 9 befindet sich der Eingang 13 der Haubenkonstruktion 8, durch den hindurch die Flachbaugruppe 6 in die Haubenkonstruktion 8 hineingeführt wird, am Auslauftunnel 12 befindet sich der Ausgang 14 der Haubenkonstruktion 8, durch den die Flachbaugruppe 6 die Haubenkonstruktion 8 wieder verlässt. Der Vorheizbereich 10 dient zum Aufwärmen der zugeführten Flachbaugruppe 6 und ist dazu mit Heizmitteln 16 ausgerüstet. Der Lötwellenbereich 11 befindet sich oberhalb des Lotbades 3 und der Lötdüsen 4,5. Die Tunnelsegmente 9, 10, 11, 12 der Haubenkonstruktion 8 sind durch jeweils gleich aufgebaute, im Folgenden näher beschriebene Klappen 15, 15', 15", 15"', 15"" strömungstechnisch voneinander trennbar ausgebildet.

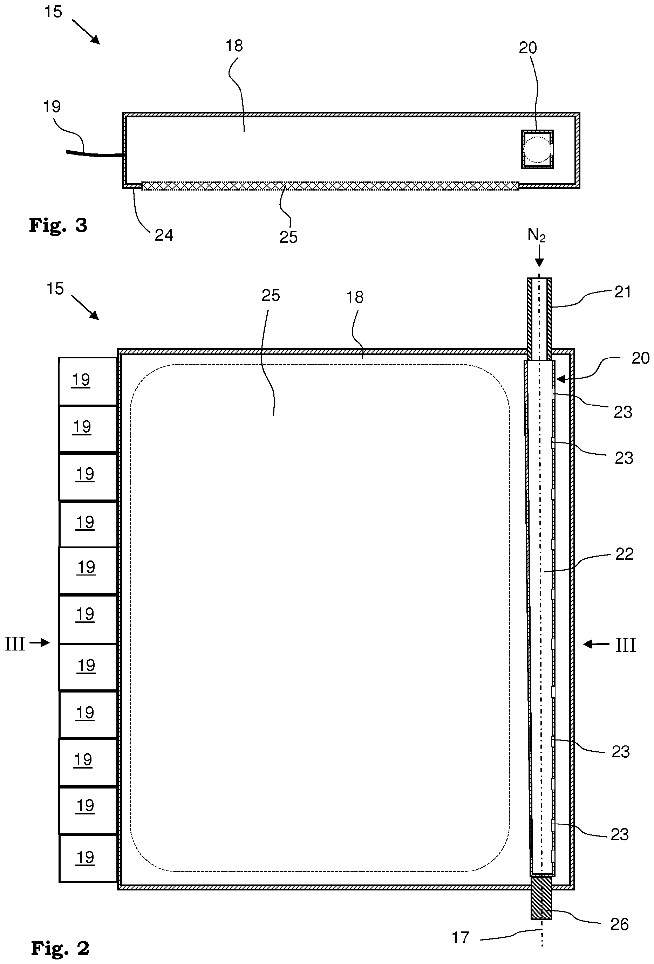

Die in den Fig. 2 und 3 beispielhaft gezeigte Klappe 15 umfasst eine schwenkbar gelagerte Hohlkammer 18, an der unterseitig Dichtelemente 19 aus einem flexiblen Material befestigt sind. Im oberen Bereich der Hohlkammer 18 ist eine Gasdüse 20 angeordnet, die mit einem Gaszuleitungsrohr 21 verbunden ist, das wiederum - hier nicht gezeigt - über eine Gaszuleitung an eine Quelle für ein Schutzgas, beispielsweise einen Druckgasbehälter oder einen Tank, angeschlossen ist. Die Gasdüse 20 umfasst eine Verteilerkammer 22, die sich horizontal nahezu über die gesamte Breite der Hohlkammer 18 erstreckt und oberseitig mit mehreren voneinander beabstandet angeordneten Gasaustrittsöffnungen 23 bestückt ist, von denen in Fig. 2 aus Gründen der Übersichtlichkeit nur einige mit Bezugszeichen versehen sind. Die Gasaustrittsöffnungen 23 können dabei einen kreisförmigen Querschnitt aufweisen oder schlitzförmig ausgebildet sein, wobei die Schlitze längs, quer oder diagonal zur Transportrichtung der Flachbaugruppen 6 in der Haubenkonstruktion 8 verlaufen können.

Bei der Gasdüse 20 kann es sich im Übrigen auch um eine Gasdüse handeln, wie sie in der EP 1 035 939 B1 oder der EP 1 779 956 A1 beschrieben wird. Diese Gasdüsen zeichnen sich dadurch aus, dass durch verschiedene, hier nicht gezeigte Maßnahmen, wie beispielsweise ein Mehrkammeraufbau oder eingebaute Strömungsdämpfer, erreicht wird, dass das Gas in einer möglichst gleichmäßigen, laminaren Strömung aus der Gasdüse austritt.

Um eine gleichmäßige Verteilung des über das Gaszuleitungsrohr 21 herangeführten Gases auf die Gasaustrittsöffnungen 23 zu erzielen, verjüngt sich der Querschnitt der Verteilerkammer 22 der Gasdüse 20 mit zunehmendem Abstand vom Gaszuleitungsrohr 21. Ein über die gesamte Länge der Gasdüse 20 gleichmäßiger Gasaustritt kann im Übrigen auch durch sich mit zunehmendem Abstand vom Gaszuleitungsrohr 21 sukzessiv vergrößernde Querschnitte der Gasaustrittsöffnungen 23 oder eine zunehmende Dichte von Gasaustrittsöffnungen 23 erzielt werden, was in Fig. 2 nur angedeutet wird.

Unterhalb der Gasdüse 20 weist die Hohlkammer 18 auf einer zur Austrittsrichtung des Gases aus den Gasaustrittsöffnungen 23 senkrechten Seitenfläche 24 eine mit einem gasdurchlässigen Strömungskörper 25 ausgefüllte Strömungsöffnung auf, die den größten Teil der Fläche dieser Seitenfläche 24 ausfüllt. Bei dem Strömungskörper 25 handelt es sich beispielsweise um ein Draht- oder Maschengeflecht. Das Material des Strömungskörpers 25 ist so gewählt, dass das aus der Hohlkammer 18 über den Strömungskörper 25 in das Innere der Haubenkonstruktion 8 einfließende Gas gleichmäßig über die gesamte Fläche des Strömungskörpers 25 verteilt aus der Hohlkammer 18 ausströmt.

Die Hohlkammer 18 ist an dem kreiszylinderförmig ausgebildeten Gaszuleitungsrohr 21 sowie an einem an der Gasdüse 20 auf deren dem Gaszuleitungsrohr 21 gegenüberliegenden Stirnseite befestigten Rundstab 26 um eine horizontale Achse 27 schwenkbar gelagert. Eine hier nicht gezeigte Motorsteuerung ermöglicht dabei die Verschwenkung jeder der Klappen 15, 15', 15", 15"', 15"" aus einer ersten Position (Schließposition), in der die Klappe 15, 15', 15", 15"', 15"" im Wesentlichen vertikal angeordnet ist und somit die Seitenfläche 24 mit dem Strömungskörper 25 eine das jeweils benachbarte Tunnelsegment 9, 10, 11, 12 abschließende Wand bildet, in eine zweite Position (Öffnungsposition), in der die Klappe 15, 15', 15", 15"', 15"" im Wesentlichen horizontal angeordnet ist, zumindest jedoch eine zum Durchfahren der Flachbaugruppe 6 hinreichende Öffnung freigibt, wobei die Seitenfläche 24 mit dem Strömungskörper 25 dem Transportweg der Flachbaugruppe 6 zugewandt ist, wie in Fig. 1 anhand der Klappe 15" gezeigt. Die Verschwenkbarkeit von der Schließposition in die Öffnungsposition ist in Fig. 1 für die übrigen Klappen 15, 15' und 15"', 15"" durch Pfeile 28 angedeutet.

Die Klappen 15, 15', 15", 15"', 15"" sind an der Haubenkonstruktion so montiert, dass eine maximale Flutung des Lötwellenbereiches 11 mit Schutzgas ermöglicht wird. So sind die Klappen 15" und 15"' in ihren Schließpositionen derart angeordnet, dass die Strömungskörper 25 in das Innere des Lötwellenbereichs 11 einmünden. Die den Vorheizbereich 10 vom Vortunnel 9 abtrennende Klappe 15' weist in ihrer Schließposition mit ihrem Strömungskörper 25 in das Innere des Vorheizbereiches 10. Die Strömungskörper 25 der im Eingang 13 und im Ausgang 14 befindlichen Klappen 15 und 15"" weisen in Schließposition jeweils in das Innere der Haubenkonstruktion 8 hinein.

Im Betrieb der Lötvorrichtung 1 werden die Tunnelsegmente 9, 10, 11, 12 mit einem Schutzgas, beispielsweise Stickstoff, einem Edelgas oder einem reduzierend wirkendem Gasgemisch geflutet, das dem Gaszuleitungsrohr 21 zugeführt wird und von dort über die Gasdüse 20, die Hohlkammer 18 und den Strömungskörper 25 in das Innere der Haubenkonstruktion 8 eingeleitet wird. Gleichzeitig werden Flachbaugruppen 6 an ihren Nutzen (Trägern) durch die Haubenkonstruktion 8 hindurchgeführt. Dabei wird der jeweilige Ort der Flachbaugruppe 6 durch hier nicht gezeigte Sensoren erfasst. Nähert sich eine Flachbaugruppe 6 einer Klappe 15, 15', 15", 15"', 15"", wird diese aus ihrer Schließposition in ihre Öffnungsposition verschwenkt. Während eine Flachbaugruppe 6 die in ihrer Öffnungsposition vorliegende Klappe 15, 15', 15", 15"', 15"" passiert, wird die Flachbaugruppe 6 mit aus dem Strömungskörper 25 dieser Klappe 15, 15', 15", 15"', 15"" austretendem Inertgas beaufschlagt. Dabei wird an der Flachbaugruppe 6 etwaig anhaftende Luft zumindest teilweise beseitigt. Nach dem Passieren der Flachbaugruppe 6 wird die Klappe 15, 15', 15", 15"', 15"" wieder in ihre Schließposition verschwenkt, in welcher die Hohlkammer 18 und die Dichtelemente 19 eine im Wesentlichen gasdichte Trennung des jeweiligen Tunnelsegments 9, 10, 11, 12 vom (in Transportrichtung gesehen) vorangegangenen Tunnelsegment 9, 10, 11 bzw. von der Umgebungsatmosphäre ermöglicht. Auf diese Weise wird der Eintrag von Luft aus der Umgebungsatmosphäre in das Innere der Haubenkonstruktion 8 wesentlich reduziert. Dadurch wird sowohl der Verbrauch an Inertgas reduziert als auch die Qualität der Lötverbindungen verbessert.

Zusätzliche Gasverteiler 29, 30 im Bereich der Lötdüsen 4, 5 oder im Lötwellenbereich 11 der Haubenkonstruktion 8, oberhalb der Lötdüsen 4, 5, wie sie beispielsweise aus der EP 1 035 939 B1 oder der EP 1 779 956 A1 bekannt sind, sind im Rahmen der Erfindung dabei nicht erforderlich, jedoch nicht ausgeschlossen. Um den Strom des aus der Hohlkammer 18 austretenden Schutzgases noch stärker zu vergleichmäßigen ist es zudem vorstellbar, auch das Innere der Hohlkammer 18 mit einem hier nicht gezeigten Strömungsdämpfer, beispielsweise mit Stahlwolle, zu füllen.

**Bezugszeichenliste**

| | | | |
|---|---|---|---|
| 1 | Lötvorrichtung | 16 | Heizmittel |
| 2 | Lotbehälter | 17 | - |
| 3 | Lotbad | 18 | Hohlkammer |
| 4 | Lötdüse | 19 | Dichtelement |
| 5 | Lötdüse | 20 | Gasdüse |
| 6 | Flachbaugruppe | 21 | Gaszuleitungsrohr |
| 7 | Pfeil | 22 | Verteilerkammer |
| 8 | Haubenkonstruktion | 23 | Gasaustrittsöffnung |
| 9 | Vortunnel | 24 | Seitenfläche |
| 10 | Vorheizbereich | 25 | Strömungskörper |
| 11 | Lötwellenbereich | 26 | Rundstab |
| 12 | Auslauftunnel | 27 | Achse |
| 13 | Eingang | 28 | Pfeil |
| 14 | Ausgang | 29 | Gasverteiler |
| 15, 15', 15", 15"', 15"" | Klappe | 30 | Gasverteiler |

## Patentansprüche

1. Lötvorrichtung zum Löten von Flachbaugruppen, mit einer einen Lotbehälter (2) abdeckenden Haubenkonstruktion (8), die einen mit einer Klappe (15, 15', 15", 15"', 15"") gegen das Eindringen von Umgebungsluft gesicherten Eingang (13) und einen mit einer Klappe (15, 15', 15", 15"', 15"") gegen das Eindringen von Umgebungsluft gesicherten Ausgang (14) für durch die Haubenkonstruktion (8) hindurchzuführende und innerhalb der Haubenkonstruktion (8) mit einer Lotwelle in Kontakt zu bringende Flachbaugruppen (6) aufweist, und mit einer Gasdüse (20) zum Einlassen und Verteilen eines Schutzgases in die Haubenkonstruktion (8), welche Gasdüse (20) zumindest einen mit zumindest einer Austrittsöffnung (23) ausgerüsteten Düsenkörper (22) umfasst,
**dadurch gekennzeichnet,**
**dass** zumindest eine Klappe (15, 15', 15", 15"', 15"") mit einer integrierten Gasdüse (20) ausgerüstet ist, wobei der Düsenkörper (22) der Gasdüse (20) innerhalb einer Hohlkammer (18) der Klappe (15, 15', 15", 15"', 15"") angeordnet ist und die Hohlkammer (18) auf einer in einem Schließzustand der Klappe (15, 15', 15", 15"', 15"") dem Innenraum der Haubenkonstruktion (8) zugewandten Seitenfläche (24) wenigstens eine Strömungsöffnung aufweist.

2. Lötvorrichtung nach Anspruch 1, **dadurch gekennzeichnet, dass** die Klappe (15, 15', 15", 15"', 15"") derart verschwenkbar an der Haube angelenkt ist, dass in einem Öffnungszustand der Klappe (15, 15', 15", 15"', 15"") die Strömungsöffnung der Hohlkammer (18) in Richtung auf eine, die jeweilige Öffnung der Haubenkonstruktion (8) durchlaufende Flachbaugruppe (6) gerichtet ist.

3. Lötvorrichtung nach einem der vorhergehenden Ansprüche, **dadurch gekennzeichnet, dass** sich die Strömungsöffnung der Hohlkammer (18) über den überwiegenden Teil der Seitenfläche (24) erstreckt.

4. Lötvorrichtung nach Anspruch 1 oder 2, **dadurch gekennzeichnet**, **dadurch gekennzeichnet, dass** die Strömungsöffnung der Hohlkammer (18) der Klappe (15, 15', 15", 15"', 15"") mit einem als Draht- oder Maschengeflecht ausgebildeten Strömungskörper (25) ausgefüllt ist.

5. Lötvorrichtung nach einem der vorhergehenden Ansprüche, **dadurch gekennzeichnet, dass** die Hohlkammer (18) zumindest teilweise mit einem Strömungsdämpfer, beispielsweise eine Füllung aus Stahlwolle, gefüllt ist.

6. Lötvorrichtung nach einem der vorhergehenden Ansprüche, **dadurch gekennzeichnet, dass** die Hohlkammer (18) der Klappe (15, 15', 15", 15"', 15"") auf ihrer im Schließzustand dem Innenraum der Haubenkonstruktion (8) zugewandten Seitenfläche (24) eine Vielzahl an voneinander beabstandeten Strömungsöffnungen umfasst.

7. Lötvorrichtung nach einem der vorhergehenden Ansprüche, **dadurch gekennzeichnet, dass** der Düsenkörper (22) sich innerhalb der Hohlkammer (18) der Klappe (15, 15', 15", 15"', 15"") quer zur Transportrichtung der Flachbaugruppen (6) erstreckt und mit einer Mehrzahl von in seiner Längsrichtung voneinander beabstandeten Austrittsöffnungen (23) ausgerüstet ist.

8. Lötvorrichtung nach einem der vorhergehenden Ansprüche, **dadurch gekennzeichnet, dass** den Austrittsöffnungen (23) ein Diffusor zum Umlenken des aus den Austrittsöffnungen (23) des Düsenkörpers (22) austretenden Gasstroms in eine breite Richtungsverteilung zugeordnet ist.

9. Lötvorrichtung nach einem der vorhergehenden Ansprüche, **dadurch gekennzeichnet, dass** sich der Innenquerschnitt des Düsenkörpers (22), ausgehend von einem mit dem Düsenkörper verbundenen Gaszuleitungsrohr (21), verjüngt.

10. Lötvorrichtung nach einem der vorhergehenden Ansprüche, **dadurch gekennzeichnet, dass** sich mit zunehmenden Abstand von einem mit dem Düsenkörper verbundenen Gaszuleitungsrohr (21) die Abstände aufeinander folgender Austrittsöffnungen (23) des Düsenkörpers (22) verkleinern und/oder die Querschnittsöffnungen der Austrittsöffnungen (23) des Düsenkörpers (22) vergrößern.

11. Lötvorrichtung nach einem der vorhergehenden Ansprüche, **dadurch gekennzeichnet, dass** die Haubenkonstruktion (8) in eine Mehrzahl von Tunnelsegmenten (9, 10, 11, 12) unterteilt ist, die jeweils durch mit einer integrierten Gasdüse (20) ausgerüsteten Klappen (15, 15', 15", 15"', 15"") strömungstechnisch voneinander trennbar sind.

## Claims

1. Soldering device for soldering flat assemblies, having a hood construction (8) that covers a solder container (2) and has an inlet (13) protected against the ingress of ambient air by means of a flap (15, 15', 15", 15''', 15'''') and an outlet (14) protected against the ingress of ambient air by means of a flap (15, 15', 15", 15''', 15''''), for flat assemblies (6) that are to be guided through the hood construction (8) and brought into contact with a solder rod inside the hood construction (8), and having a gas nozzle (20) for introducing and distributing a shield gas into the hood construction (8), which gas novel (20) comprises at least one nozzle body (22) equipped with at least one outlet opening (23),
**characterized in that**
at least one flap (15, 15', 15", 15''', 15'''') is equipped with an integrated gas nozzle (20), wherein the nozzle body (22) of the gas nozzle (20) is arranged within a cavity (18) of the flap (15, 15', 15", 15''', 15''''), and the cavity (18) has at least one flow opening on a side surface (24) that, in a closed state of the flap (15, 15', 15", 15''', 15''''), is oriented towards the interior of the hood construction (8).

2. Soldering device according to Claim 1,
**characterized in that** the flap (15, 15', 15", 15''', 15'''') is hinged on the hood so as to be pivotable such that, in an open state of the flap (15, 15', 15", 15''', 15''''), the flow opening of the cavity (18) is oriented towards a flat assembly (6) passing through the respective opening of the hood construction (8).

3. Soldering device according to either of the preceding claims, **characterized in that** the flow opening of the cavity (18) extends over the majority of the side surface (24).

4. Soldering device according to Claim 1 or 2,
**characterized in that** the flow opening of the cavity (18) of the flap (15, 15', 15", 15''', 15'''') is filled with a flow body (25) in the form of a wire mesh or metal mesh.

5. Soldering device according to one of the preceding claims, **characterized in that** the cavity (18) is at least partially filled with a flow damper, for example a filling of steel wool.

6. Soldering device according to one of the preceding claims, **characterized in that** the cavity (18) of the flap (15, 15', 15", 15''', 15'''') comprises a multiplicity of flow openings, which are spaced apart from one another, on its side surface (24) that, in the closed state, is oriented towards the interior of the hood construction (8).

7. Soldering device according to one of the preceding claims, **characterized in that** the nozzle body (22) extends within the cavity (18) of the flap (15, 15', 15", 15''', 15''''), transversely to the transport direction of the flat assemblies (6), and is equipped with a plurality of outlet openings (23) that are spaced apart from one another in its longitudinal direction.

8. Soldering device according to one of the preceding claims, **characterized in that** the outlet openings (23) are assigned a diffuser for redirecting the gas flow issuing from the outlet openings (23) of the nozzle body (22) into a broad direction distribution.

9. Soldering device according to one of the preceding claims, **characterized in that** the internal cross section of the nozzle body (22) narrows from a gas supply pipe (21) connected to the nozzle body.

10. Soldering device according to one of the preceding claims, **characterized in that**, with increasing distance from a gas supply pipe (21) connected to the nozzle body, the distances between subsequent outlet openings (23) of the nozzle body (22) reduce and/or the cross-sectional openings of the outlet openings (23) of the nozzle body (22) increase.

11. Soldering device according to one of the preceding claims, **characterized in that** the hood construction (8) is divided into a plurality of tunnel segments (9, 10, 11, 12) which can each be fluidically separated from one another by means of flaps (15, 15', 15", 15''', 15'''') equipped with an integrated gas nozzle (20).

## Revendications

1. Dispositif de brasage pour le brasage de modules plats, comprenant une construction de capot (8) recouvrant un récipient de métal d'apport (2), qui présente une entrée (13) protégée avec un clapet (15, 15', 15", 15''', 15'''') contre la pénétration d'air ambiant et une sortie (14) protégée avec un clapet (15, 15', 15", 15''', 15'''') contre la pénétration d'air ambiant, pour les modules plats (6) devant être acheminés à travers la construction de capot (8) et devant être mis en contact avec une onde de brasage à l'intérieur de la construction de capot (8), et comprenant une buse à gaz (20) pour l'introduction et la distribution d'un gaz protecteur dans la construction de capot (8), laquelle buse à gaz (20) comprend au moins un corps de buse (22) équipé d'au moins une ouverture de sortie (23), **caractérisé en ce**
**qu'**au moins un clapet (15, 15', 15", 15''', 15'''') est muni d'une buse à gaz intégrée (20), le corps de buse (22) de la buse à gaz (20) étant disposé dans une chambre creuse (18) du clapet (15, 15', 15", 15"', 15'''') et la chambre creuse (18) présentant au moins une ouverture d'écoulement sur une surface latérale (24) tournée vers l'espace interne de la construction de capot (8) dans un état fermé du clapet (15, 15', 15", 15"', 15'''').

2. Dispositif de brasage selon la revendication 1, **caractérisé en ce que** le clapet (15, 15', 15", 15''', 15'''') est articulé au capot de manière pivotante de telle sorte que dans un état ouvert du clapet (15, 15', 15", 15''', 15''''), l'ouverture d'écoulement de la chambre creuse (18) soit orientée dans la direction d'un module plat (6) passant à travers l'ouverture respective de la construction de capot (8).

3. Dispositif de brasage selon l'une quelconque des revendications précédentes, **caractérisé en ce que** l'ouverture d'écoulement de la chambre creuse (18) s'étend sur la majeure partie de la surface latérale (24).

4. Dispositif de brasage selon la revendication 1 ou 2, **caractérisé en ce que** l'ouverture d'écoulement de la chambre creuse (18) du clapet (15, 15', 15", 15''', 15'''') est remplie avec un corps d'écoulement (25) réalisé sous forme de treillis métallique ou de grillage.

5. Dispositif de brasage selon l'une quelconque des revendications précédentes, **caractérisé en ce que** la chambre creuse (18) est remplie au moins en partie avec un ralentisseur de débit, par exemple une charge en laine d'acier.

6. Dispositif de brasage selon l'une quelconque des revendications précédentes, **caractérisé en ce que** la chambre creuse (18) du clapet (15, 15', 15", 15''', 15'''') comprend, sur sa surface latérale (24) tournée vers l'espace interne de la construction de capot (8) dans l'état fermé, une pluralité d'ouvertures d'écoulement espacées les unes des autres.

7. Dispositif de brasage selon l'une quelconque des revendications précédentes, **caractérisé en ce que** le corps de buse (22) s'étend transversalement à la direction de transport des modules plats (6) à l'intérieur de la chambre creuse (18) du clapet (15, 15' 15", 15"', 15'''') et est muni d'une pluralité d'ouvertures de sortie (23) espacées les unes des autres dans sa direction longitudinale.

8. Dispositif de brasage selon l'une quelconque des revendications précédentes, **caractérisé en ce qu'**un diffuseur pour dévier le flux de gaz sortant des ouvertures de sortie (23) du corps de buse (22) dans une vaste distribution directionnelle est associé aux ouvertures de sortie (23).

9. Dispositif de brasage selon l'une quelconque des revendications précédentes, **caractérisé en ce que** la section transversale intérieure du corps de buse (22) se rétrécit en partant d'un tube d'alimentation de gaz (21) connecté au corps de buse.

10. Dispositif de brasage selon l'une quelconque des revendications précédentes, **caractérisé en ce que** les espacements d'ouvertures de sortie successives (23) du corps de buse (22) diminuent, et/ou les ouvertures en section transversale des ouvertures de sortie (23) du corps de buse (22) augmentent, en s'éloignant d'un tube d'alimentation de gaz (21) connecté au corps de buse.

11. Dispositif de brasage selon l'une quelconque des revendications précédentes, **caractérisé en ce que** la construction de capot (8) est divisée en une pluralité de segments de tunnel (9, 10, 11, 12) qui peuvent être séparés les uns des autres par une technique fluidique à chaque fois par le biais de clapets (15, 15', 15", 15''', 15'''') munis d'une buse à gaz intégrée (20).
